# EUROPÄISCHE PATENTSCHRIFT

(11) **EP 3 413 282 B1**
(45) Veröffentlichungstag und Bekanntmachung des Hinweises auf die Patenterteilung: **04.03.2020**
(21) Anmeldenummer: 18176184.2
(22) Anmeldetag: 06.06.2018
(51) Int. Cl.: G08C 19/02

(54) **MESSUMFORMERSPEISEGERÄT UND SYSTEM**
MEASUREMENT TRANSDUCER FEED DEVICE AND SYSTEM
APPAREIL D'ALIMENTATION DU TRANSDUCTEUR DE MESURE ET SYSTÈME

(30) Priorität: 09.06.2017 DE 102017112755
(43) Veröffentlichungstag der Anmeldung: 12.12.2018
(73) Patentinhaber: SICK Engineering GmbH, 01458 Ottendorf-Okrilla (DE)
(72) Erfinder: WALDE, David, 01920 Steina (DE)
(74) Vertreter: Manitz Finsterwald Patent- und Rechtsanwaltspartnerschaft mbB

(56) Entgegenhaltungen:
- DE-A1-102007 035 710
- DE-A1-102009 034 419
- DE-A1-102011 087 157

## Beschreibung

Die vorliegende Erfindung betrifft ein Messumformerspeisegerät für die Prozessautomatisierungstechnik, welches zur Energieversorgung eines Messumformers und zur Weiterleitung von Messsignalen des Messumformers an eine Steuereinheit ausgebildet ist. Das Messumformerspeisegerät weist zumindest zwei Anschlusskontakte auf, die zur Kopplung des Messumformerspeisegeräts mit der Steuereinheit ausgebildet sind, wobei zwischen den Anschlusskontakten eine Stromschleife gebildet ist und die Stromschleife einen Leistungsabgriff umfasst, welcher ausgebildet ist, den Messumformer mit elektrischer Energie zu versorgen. Die Dokumente DE 10 2007 035 710 A1, DE 10 2009 034 419 A1 und DE 10 2011 087 157 A1 offenbaren Messumformerspeisegeräte gemäß dem Oberbegriff des Anspruchs 1.

Messumformerspeisegeräte dienen dazu, Messumformer, wie beispielsweise Temperatur- oder Feuchtigkeitssensoren, mit elektrischer Energie zu versorgen. Zugleich dient das Messumformerspeisegerät dazu, Messdaten bzw. Messsignale des Messumformers an die Steuereinheit zu übermitteln. Insbesondere können die Messsignale mittels eines Stromsignals, beispielsweise im Bereich zwischen 4 und 20 mA übertragen werden. Hierzu wird in die Stromschleife zwischen den Anschlusskontakten ein entsprechender Strom eingeprägt. Zum Einprägen des Stroms in die Stromschleife kann das Messumformerspeisegerät einen Stromregelbaustein umfassen, der das Messsignal des Messumformers in eine jeweilige Stromstärke umsetzt. Anhand des eingeprägten Stroms kann die an das Messumformerspeisegerät angeschlossene Steuereinheit dann auf das Messsignal bzw. den Messwert des Messumformers rückschließen.

Zur Versorgung des Messumformers ist maximal der in die Stromschleife eingeprägte Strom multipliziert mit der am Messumformer anliegenden Spannung als elektrische Energie verfügbar. Aufgrund des geringen eingeprägten Stroms (beispielsweise 4 bis 20 mA) ist die zur Verfügung stehende Leistung sehr gering.

Neben dem Messsignal, welches (niederfrequent) mittels des eingeprägten Stroms an die Steuereinheit übermittelt wird, können zusätzliche Daten zwischen der Steuereinheit und dem Messumformerspeisegerät beispielsweise mittels des HART-Kommunikationssystems bzw. HART-Protokolls (Highway Addressable Remote Transducer) übertragen werden, welches mittels hochfrequenter Signale ein zusätzliches Datensignal auf den Strom der Stromschleife aufmoduliert.

Herkömmlicherweise erfolgt die Versorgung des Messumformers mit elektrischer Energie beispielsweise über einen Linearregler, gegebenenfalls mit einer Strombegrenzung. Der Linearregler wirkt dabei als Tiefpass, um eine genügend hohe Impedanz für das HART-Kommunikationssystem bereitzustellen. Auch bei einem parallelen Leistungsabgriff, bei welchem der Messumformer parallel zu dem Stromregelbaustein geschaltet ist, muss in Serie zu dem Messumformer ein Tiefpass geschaltet sein, so dass das hochfrequente Signal des HART-Kommunikationssystems nicht über den niedrigimpedanten Messumformer oder eine relativ große zu dem Messumformer parallel geschaltete Kapazität im Hochfrequenzbereich kurzgeschlossen wird.

Nachteiligerweise benötigt der Tiefpass und auch die Strombegrenzung einen Teil der über die Stromschleife zur Verfügung gestellten Energie, so dass die für den Messumformer zur Verfügung stehende elektrische Energie reduziert ist.

Es ist deshalb die der Erfindung zugrundeliegende Aufgabe, ein Messumformerspeisegerät anzugeben, welches eine geringe Verlustleistung aufweist und in der Folge eine höhere elektrische Leistung dem Messumformer zur Verfügung stellen kann.

Diese Aufgabe wird durch ein Messumformerspeisegerät gemäß Anspruch 1 gelöst.

Erfindungsgemäß ist vorgesehen, dass die Stromschleife einen Stromregelbaustein umfasst, welcher in Reihe zu dem Leistungsabgriff und dem Messumformer geschaltet ist oder schaltbar ist.

Die Erfindung stützt sich auf die Erkenntnis, dass durch die Schaltung des Stromregelbausteins in Reihe zu dem Leistungsabgriff und in Reihe zu dem Messumformer der üblicherweise hochimpedante Stromregelbaustein unabhängig vom Betriebszustand oder der konkreten Ausbildung des Messumformers eine hohe Impedanz der Stromschleife bereitstellt. Diese hohe Impedanz ermöglicht die korrekte Funktion beispielsweise eines HART-Kommunikationssystems.

Die hohe Impedanz des Stromregelbausteins kann insbesondere dadurch erzielt werden, dass der Stromregelbaustein, bevorzugt entlang der Stromschleife, nur eine geringe Kapazität aufweist (beispielsweise maximal 10 nF, bevorzugt maximal 5 nF). Eine sehr große, in Reihe zum Stromregelbaustein geschaltete Kapazität z.B. des Messumformers oder des Leistungsabgriffs erniedrigt die Gesamtimpedanz der Stromschleife aufgrund der Reihenschaltung dann nicht.

Von besonderem Vorteil ist zusätzlich, dass auf einen Tiefpass verzichtet werden kann, da durch die erfindungsgemäße Schaltung von Leistungsabgriff, Messumformer und Stromregelbaustein eine sehr niedrige Impedanz des Messumformers praktisch keine Auswirkungen auf die Gesamtimpedanz der Stromschleife besitzt. Hierdurch kann erfindungsgemäß die üblicherweise in dem Tiefpass "unnütz" verbrauchte Energie für den Betrieb des Messumformers zur Verfügung gestellt werden, wodurch dem Messumformer mehr elektrische Energie bereitgestellt werden kann.

Beispielsweise können bei einer an den zwei Anschlusskontakten der Stromschleife anliegenden Spannung von 24 V und einem Strom von 4 mA herkömmlicherweise etwa 60 mW elektrischer Leistung für den Betrieb des Messumformers zur Verfügung gestellt werden. Durch das Einsparen bzw. Weglassen des Tiefpasses können zusätzlich 5 bis 8 mW mehr dem Messumformer beim Betrieb zur Verfügung stehen. Hierdurch kann das Messumformerspeisegerät flexibler eingesetzt und auch mit leistungsfordernden Messumformern gekoppelt werden.

Kurz gesagt benötigt das erfindungsgemäße Messumformerspeisegerät keinen die Funktion des HART-Kommunikationssystems bzw. die Kommunikation mittels hochfrequenter Signale ermöglichenden Tiefpass, so dass die in dem Tiefpass herkömmlicherweise abfallende Verlustleistung durch den Messumformer genutzt werden kann.

Überdies ist durch die erfindungsgemäße Serienschaltung von Leistungsabgriff und Messumformer einerseits und dem Stromregelbaustein andererseits das Einprägen des jeweils erforderlichen Stromes zur Übertragung der Messsignale auf einfache Art und Weise möglich, da der Stromregelbaustein ohne Rücksicht auf den Messumformer den einzuprägenden Strom einstellen kann. Beispielsweise kann der Stromregelbaustein von dem Leistungsabgriff mit elektrischer Energie versorgt werden.

Rein klarstellend sei ausgeführt, dass bei dem erfindungsgemäßen Messumformerspeisegerät der Stromregelbaustein so geschaltet ist, dass der Stromregelbaustein in Reihe zu dem Messumformer geschaltet ist, sobald der Messumformer elektrisch mit dem Messumformerspeisegerät (z.B. an den nachstehend erläuterten Versorgungskontakten) verbunden ist. Der Messumformer ist nicht Bestandteil des Messumformerspeisegeräts.

Vorteilhafte Weiterbildungen der Erfindung sind der Beschreibung, den Unteransprüchen sowie der Zeichnung zu entnehmen.

Bevorzugt ist eine effektive Kapazität der Stromschleife kleiner als 50 nF oder kleiner als 10 nF, bevorzugt kleiner als 5 nF. Dies bedeutet, die Kapazität, welche (z.B. im Ersatzschaltbild) effektiv direkt zwischen den Anschlussklemmen vorliegt ist z.B. kleiner als 10 nF, bevorzugt kleiner als 5 nF. Durch die auf diese Weise geschaffene hohe Impedanz der Stromschleife, ist die Überlagerung des Stromsignals auf der Stromschleife mit einem zusätzlichen hochfrequenten Signal, z.B. eines HART-Kommunikationssystems, möglich. Die hohe Impedanz bezieht sich insbesondere auf den Frequenzbereich zwischen 1 kHz und 3 kHz und bevorzugt auf den von dem HART-Kommunikationssystem verwendeten Frequenzbereich zwischen 1,2 kHz und 2,2 kHz.

Erfindungsgemäß umfasst das Messumformerspeisegerät eine Konstantspannungsquelle, welche dem Stromregelbaustein eine konstante Spannung bereitstellt.

Die Konstantspannungsquelle kann beispielsweise eine Zener-Diode umfassen, welche insbesondere gegen Masse geschaltet ist. Durch die konstante Spannung an dem Stromregelbaustein können die Anforderungen an den Stromregelbaustein reduziert werden, da der Stromregelbaustein nicht auf stark schwankende Spannungen ausgelegt sein muss. Überdies ist von Vorteil, dass durch die konstante Spannung an dem Stromregelbaustein auch die "verbleibende" Spannung an dem Messumformer zumindest im Wesentlichen konstant ist, wodurch auch für den Betrieb des Messumformers geringere Anforderungen herrschen.

Gemäß einer weiteren vorteilhaften Ausführungsform umfasst der Leistungsabgriff einen Transistor oder Bipolartransistor, insbesondere einen NPN-Transistor, dessen Kollektor und Emitter zwischen einen der Anschlusskontakte und den Stromregelbaustein geschaltet sind. Vorteilhafterweise ist der Kollektor des NPN-Transistors elektrisch, bevorzugt direkt, mit einem der Anschlusskontakte gekoppelt, wohingegen der Emitter des NPN-Transistors elektrisch, bevorzugt direkt, mit dem Stromregelbaustein gekoppelt ist.

An der Basis des NPN-Transistors kann die von der Konstantspannungsquelle gelieferte konstante Spannung anliegen. Alternativ oder zusätzlich kann durch die Konstantspannungsquelle auch ein konstanter Strom für den Leistungsabgriff bereitgestellt werden, beispielsweise indem die konstante Spannung an einen Widerstand angelegt wird. Die konstante Spannung und/oder der konstante Strom können an der Basis des NPN-Transistors anliegen, wodurch der NPN-Transistor auch als Konstantspannungsquelle für den Messumformer wirken kann. Der Messumformer ist bevorzugt zwischen einem Eingang des Leistungsabgriffs (beispielsweise dem Kollektor) und einem Ausgang des Leistungsabgriffs (beispielsweise dem Emitter) angeschlossen und somit parallel zu dem Leistungsabgriff geschaltet.

Alternativ oder zusätzlich zu dem NPN-Transistor kann auch ein CMOS-Transistor oder eine andere Transistortechnologie verwendet werden.

Das Messumformerspeisegerät kann bevorzugt zumindest zwei Versorgungskontakte umfassen, an welche der Messumformer angeschlossen werden kann. Die Versorgungskontakte können elektrisch an dem Leistungsabgriff angeschlossen sein. Beispielsweise ist ein erster Versorgungskontakt, insbesondere direkt, an den Eingang des Leistungsabgriffs und ein zweiter Versorgungskontakt, insbesondere direkt, an den Ausgang des Leistungsabgriffs angeschlossen.

Gemäß einer weiteren vorteilhaften Ausführungsform ist der Stromregelbaustein ausgebildet, einen von den Messsignalen des Messumformers abhängigen Strom in die Stromschleife einzuprägen. Bei den Messsignalen des Messumformers kann es sich um eine analoge und/oder digitale Repräsentation des von dem Messumformer gemessenen Wertes handeln. Der von dem Stromregelbaustein eingeprägte Strom in der Stromschleife kann bevorzugt im Bereich von 4 bis 20 mA liegen, wobei beispielsweise ein Strom von 4 mA einen minimalen Messwert des Messumformers darstellt und ein Strom von 20 mA einen maximalen Messwert des Messumformers repräsentiert. Es kann sich damit um einen messwertabhängigen Strom in der Stromschleife handeln.

Der von dem Stromregelbaustein eingeprägte Strom in der Stromschleife kann auch einen erweiterten Stellbereich aufweisen und bevorzugt im Bereich von 3,5 bis 21,5 mA oder sogar 24 mA liegen.

Gemäß einer weiteren vorteilhaften Ausführungsform umfasst das Messumformerspeisegerät eine Modulationseinheit, welche ein auf den Strom der Stromschleife aufzumodulierendes Datensignal erzeugt. Bei dem Datensignal kann es sich beispielsweise um ein hochfrequentes Signal handeln, das das Stromsignal überlagert, durch seine hochfrequenten Eigenschaften aber die Auswertung des Stromsignals in der Steuereinheit bevorzugt nicht beeinflusst. Insbesondere kann die Modulationseinheit Teil eines HART-Kommunikationssystems sein (Highway Addressable Remote Transducer-Kommunikationssystem) und/oder nach dem HART-Protokoll arbeiten. Dementsprechend kann die Modulationseinheit auch als HART-Modul bezeichnet werden. Insbesondere verwendet die Modulationseinheit eine Frequenzumtastung (Frequency Shift Keying - FSK), um das Datensignal auf den Strom der Stromschleife aufzumodulieren. Beispielsweise kann die hierzu verwendete hochfrequente Schwingung eine Stromstärke von ±0,5 mA erzeugen, wobei z.B. eine digitale Eins mit einer Frequenz von 1,2 kHz und eine digitale Null mit einer Frequenz von 2,2 kHz dargestellt werden.

Gemäß einer weiteren vorteilhaften Ausführungsform ist die Modulationseinheit mit dem Stromregelbaustein gekoppelt, wobei der Stromregelbaustein ausgebildet ist, das von der Modulationseinheit vorgegebene Datensignal auf den Strom der Stromschleife aufzumodulieren. Das Datensignal wird also von der Modulationseinheit vorgegeben und an den Stromregelbaustein übertragen, wobei der Stromregelbaustein dann das Einspeisen des Datensignals in die Stromschleife vornimmt. Hierzu kann der Stromregelbaustein, auch bevorzugt kapazitiv, mit der Stromschleife gekoppelt sein, um das hochfrequente Datensignal auf den Strom der Stromschleife aufzumodulieren. Alternativ oder zusätzlich kann auch die Modulationseinheit selbst, insbesondere kapazitiv, mit der Stromschleife gekoppelt sein und das Datensignal selbst auf den Strom der Stromschleife aufmodulieren.

Die Modulationseinheit kann über ihre, insbesondere kapazitive, Kopplung auch auf den Strom der Stromschleife aufmodulierte Daten empfangen. Mittels der Modulationseinheit kann eine bidirektionale Kommunikation mit der Steuereinheit möglich sein.

Die Modulationseinheit ist bevorzugt mittels eines Koppelkondensators mit der Stromschleife elektrisch verbunden.

Bevorzugt sind der Stromregelbaustein und/oder der Messumformer mittels jeweils einer Datenverbindung mit der Modulationseinheit gekoppelt oder koppelbar. Die Datenverbindungen zwischen Stromregelbaustein und Modulationseinheit und zwischen Messumformer und Modulationseinheit ermöglichen es, über das Datensignal beispielsweise auch Parameter oder Einstellungen des Messumformers und/oder des Messumformerspeisegeräts mittels des Datensignals auszulesen und/oder festzulegen. Insbesondere erfolgt mittels des Datensignals und der Modulationseinheit eine bidirektionale Kommunikation zwischen der Steuereinheit und dem Messumformerspeisegerät. Beispielsweise kann es möglich sein, einen maximalen Messbereich des Messumformers mittels des Datensignals auszulesen oder eine Abtastrate des Messumformers mittels des Datensignals festzulegen. Die Datenverbindungen können Daten digital und bevorzugt bidirektional übertragen. Die Datenverbindungen können jeweils eine galvanische Trennung umfassen. Beispielsweise können die Datenverbindungen oder zumindest eine der Datenverbindungen auf optischer und/oder induktiver Übertragung basieren.

Gemäß einer weiteren vorteilhaften Ausführungsform umfasst das Messumformerspeisegerät eine Pufferkapazität, welche eine Größe von zumindest 100 nF, bevorzugt von zumindest 1 µF, aufweist und mit dem Leistungsabgriff gekoppelt ist, um Verbrauchsspitzen des Messumformers abzufangen. Die Pufferkapazität kann grundsätzlich größer sein, als für das HART-Kommunikationssystem eigentlich zulässig. Die Pufferkapazität kann insbesondere parallel zu dem Messumformer und/oder den Versorgungskontakten geschaltet sein. Beispielsweise beim Einschalten des Messumformers können kurzzeitig höhere Leistungsanforderungen des Messumformers auftreten (die z.B. die oben erwähnten 50 mW übersteigen). Diese Verbrauchsspitzen des Messumformers können durch die Pufferkapazität abgefedert werden, auch wenn der Strom in der Stromschleife für den Energieverbrauch während der Verbrauchsspitze nicht ausreichen würde.

Zwischen den Leistungsabgriff und den Messumformer oder die Versorgungskontakte können auch eine Glättungsinduktivität und/oder eine Gleichtaktdrossel geschaltet sein. Durch die Glättungsinduktivität und/oder die Gleichtaktdrossel können unerwünschte Strom- und Spannungsspitzen herausgefiltert werden, bevor diese zu dem Messumformer gelangen.

Bevorzugt stellt das Messumformerspeisegerät eine galvanische Trennung zwischen der Stromschleife und dem Messumformer bereit. Hierzu kann das Messumformerspeisegerät beispielsweise einen Transformator aufweisen, welcher zwischen den Leistungsabgriff und den Messumformer und/oder zwischen den Leistungsabgriff und die Versorgungskontakte geschaltet ist oder schaltbar ist.

Weiter bevorzugt kann das Messumformerspeisegerät derart ausgebildet sein, dass es an einer Hutschiene befestigt werden kann. Überdies kann das Messumformerspeisegerät explosionsgeschützt ausgeführt sein.

Weiterer Gegenstand der Erfindung ist ein System mit zumindest einem Messumformerspeisegerät der vorstehend erläuterten Art, einer mit den beiden Anschlusskontakten des Messumformerspeisegeräts elektrisch verbundenen Steuereinheit und einem Messumformer, welcher von dem Messumformerspeisegerät mit elektrischer Energie versorgt wird.

Die Steuereinheit kann eine Spannungsversorgung und ein Steuergerät für das HART-Kommunikationssystem ("HART-Master") umfassen. Die Spannungsversorgung kann für das HART-Kommunikationssystem ausgelegt sein ("hartfähige Spannungsversorgung"). Die Spannungsversorgung und das Steuergerät für das HART-Kommunikationssystem können in einem Gerät kombiniert oder getrennt verbaut sein. Die Steuereinheit kann auch eine speicherprogrammierbare Steuerung (SPS) umfassen.

Vorteilhafterweise ist die Steuereinheit an den Anschlusskontakten des Messumformerspeisegeräts angeschlossen, wohingegen der Messumformer elektrisch mit den Versorgungskontakten des Messumformerspeisegeräts verbunden ist. Die Steuereinheit, das Messumformerspeisegerät und der Messumformer sind bevorzugt separat voneinander ausgebildet, wobei zwischen der Steuereinheit, dem Messumformerspeisegerät und dem Messumformer jeweils elektrische Verbindungsleitungen von mehreren Metern Länge angeordnet sein können.

Die Steuereinheit kann an den Anschlusskontakten eine konstante Spannung bereitstellen, beispielsweise 24 V, wobei die Steuereinheit durch die konstante Spannung das Messumformerspeisegerät und/oder den Messumformer mit elektrischer Energie versorgt.

Die vorstehend getroffenen Ausführungen und Erläuterungen, insbesondere hinsichtlich bevorzugten Ausführungsformen und Vorteilen, gelten für das erfindungsgemäße System entsprechend.

Gemäß einer vorteilhaften Ausführungsform des erfindungsgemäßen Systems ist der Messumformer ein Temperatursensor, ein Spannungssensor, ein Stromsensor, ein Durchflusssensor oder ein Annäherungssensor.

Nachfolgend wird die Erfindung rein beispielhaft unter Bezugnahme auf die Zeichnung beschrieben. Es zeigt:

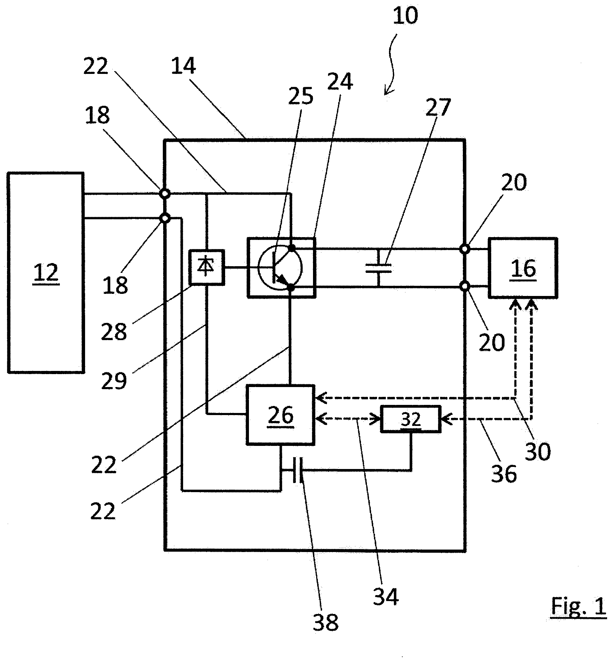

- Fig. 1: ein System aus einer speicherprogrammierbaren Steuerung, einem Messumformerspeisegerät und einem Messumformer in schematischer Darstellung.

Fig. 1 zeigt ein System 10, welches zur Erfassung von Messwerten dient. Das System 10 umfasst eine speicherprogrammierbare Steuerung (SPS) 12, ein Messumformerspeisegerät 14 und einen Messumformer 16, beispielsweise einen Temperatursensor.

Die SPS 12 umfasst eine Spannungsversorgung und einen HART-Master (beide nicht gezeigt). Die SPS 12 ist an zwei Anschlusskontakten 18 elektrisch mit dem Messumformerspeisegerät 14 verbunden. Der Messumformer 16 wiederum ist an zwei Versorgungskontakten 20 mit dem Messumformerspeisegerät 14 elektrisch verbunden.

Zwischen den Anschlusskontakten 18 ist eine Stromschleife 22 in dem Messumformerspeisegerät 14 vorgesehen. Die Stromschleife 22 wird innerhalb der SPS 12 geschlossen.

Die Stromschleife 22 umfasst einen Leistungsabgriff 24, welcher einen NPN-Transistor 25 in Emitterschaltung umfasst. Der Leistungsabgriff 24 stellt sowohl für den Messumformer 16 als auch für einen dem Leistungsabgriff 24 nachgeschalteten Stromregelbaustein 26 jeweils eine konstante Spannung zur Verfügung. Der Messumformer 16 ist parallel zu dem NPN-Transistor 25 des Leistungsabgriffs 24 geschaltet. Hierzu ist einer der Versorgungskontakte 20 an den Kollektor des NPN-Transistors 25 und der andere der Versorgungskontakte 20 an den Emitter des NPN-Transistors 25 angeschlossen. Zwischen die Versorgungskontakte ist eine Pufferkapazität 27 geschaltet, die Leistungsspitzen im elektrischen Energiebedarf des Messumformers 16 auffängt. Die Pufferkapazität 27 besitzt eine Größe von zumindest 1 µF.

Um die konstante Spannung zu erzeugen, ist der Leistungsabgriff 24 bzw. die Basis des NPN-Transistors des Leistungsabgriffs 24 mit einer Konstantspannungsquelle 28 elektrisch verbunden. Genauer gesagt, stellt also die Kombination von Leistungsabgriff 24 und Konstantspannungsquelle 28 dem Stromregelbaustein 26 eine konstante Spannung zur Verfügung. Die Konstantspannungsquelle 28 umfasst eine Zener-Diode, die mit einem ersten Anschluss mit einem der Anschlusskontakte 18 elektrisch verbunden ist. Der andere Anschluss der Zener-Diode kann mit Masse bzw. dem anderen Anschlusskontakt elektrisch verbunden sein. Auch der Stromregelbaustein 26 kann mittels einer Verbindungsleitung 29 mit Masse verbunden sein und/oder durch die Verbindungsleitung 29 dasselbe Bezugspotential besitzen, wie die Konstantspannungsquelle 28.

Für den Messumformer 16 steht in etwa eine elektrische Leistung zur Verfügung, die der von der SPS 12 an den Anschlusskontakten bereitgestellten Spannung, abzüglich der an dem Stromregelbaustein 26 abfallenden Spannung, multipliziert mit dem Strom in der Stromschleife 22 entspricht.

Der Stromregelbaustein 26 ist mittels einer ersten Datenverbindung 30 mit dem Messumformer 16 gekoppelt, wobei der Messumformer 16 dem Stromregelbaustein 26 über die erste Datenverbindung 30 seinen jeweiligen Messwert (d.h. das Messsignal) übermittelt. Aufgrund des Messwerts prägt der Stromregelbaustein 26 einen messwertabhängigen Strom im Bereich von 4 bis 20 mA in die Stromschleife 22 ein.

Das Messumformerspeisegerät 14 umfasst überdies ein HART-Modul (Highway Addressable Remote Transducer-Modul) 32, welches mittels einer zweiten Datenverbindung 34 mit dem Stromregelbaustein und mittels einer dritten Datenverbindung 36 mit dem Messumformer gekoppelt ist. Das HART-Modul 32 (welches auch als Modulationseinheit bezeichnet werden kann) erzeugt hochfrequente Signale, die von dem Stromregelbaustein 26 auf den Strom in der Stromschleife 22 aufmoduliert werden, um digitale Daten an die SPS 12 zu übertragen. In entsprechender Weise empfängt das HART-Modul 32 auch hochfrequente Daten, die von der SPS 12 über die Stromschleife 22 gesendet werden. Hierzu ist das HART-Modul 32 mittels eines Koppelkondensators 38 mit der Stromschleife 22 kapazitiv gekoppelt. Mittels des HART-Moduls 32 können zusätzlich zu dem von dem Stromregelbaustein 26 eingeprägten analogen Stromsignal digitale Daten zwischen dem Messumformerspeisegerät 14 und der SPS 12 ausgetauscht werden. Hierdurch können beispielsweise Parameter des Messumformers 16 ausgelesen oder gesetzt werden.

Aufgrund der Reihenschaltung des Stromregelbausteins 26 relativ zu dem Leistungsabgriff 24 und dem Messumformer 16 weist die Stromschleife 22 immer eine hohe Impedanz auf, da der Stromregelbaustein 26 eine hohe Impedanz aufweist. Beispielsweise kann die hohe Impedanz des Stromregelbausteins 26 darin begründet sein, dass der Stromregelbaustein 26 maximal eine Kapazität (entlang der Stromschleife 22) von 10 nF aufweist. Wegen der Reihenschaltung umfasst deshalb auch in diesem Bespiel die gesamte Stromschleife 22 effektiv maximal eine Kapazität von 10 nF zwischen den Anschlusskontakten 18. Damit weist die Stromschleife 22 eine hohe Impedanz auf, insbesondere im vom HART-Modul 32 verwendeten Frequenzbereich.

Hierdurch wird es ermöglicht, dass kein separater Tiefpass benötigt wird, der die Funktion des HART-Moduls 32 bzw. die Kommunikation mittels hochfrequenter Signale ermöglicht. Die in dem Tiefpass üblicherweise verbrauchte Leistung kann nun dem Messumformer 16 zur Verfügung gestellt werden, wodurch Messumformer 16 mit höherem Leistungsbedarf an dem Messumformerspeisegerät 14 betrieben werden können.

### Bezugszeichenliste

- 10: System
- 12: SPS
- 14: Messumformerspeisegerät
- 16: Messumformer
- 18: Anschlusskontakt
- 20: Versorgungskontakt
- 22: Stromschleife
- 24: Leistungsabgriff
- 25: NPN-Transistor
- 26: Stromregelbaustein
- 27: Pufferkapazität
- 28: Konstantspannungsquelle
- 29: Verbindungsleitung
- 30: erste Datenverbindung
- 32: HART-Modul
- 34: zweite Datenverbindung
- 36: dritte Datenverbindung
- 38: Koppelkondensator

## Patentansprüche

1. Messumformerspeisegerät (14) für die Prozessautomatisierungstechnik, welches zur Energieversorgung eines Messumformers (16) und zur Weiterleitung von Messsignalen des Messumformers (16) an eine Steuereinheit (12) ausgebildet ist,
wobei das Messumformerspeisegerät (14) zumindest zwei Anschlusskontakte (18) aufweist, die zur Kopplung des Messumformerspeisegeräts (14) mit der Steuereinheit (12) ausgebildet sind, wobei zwischen den zwei Anschlusskontakten (18) eine Stromschleife (22) gebildet ist, wobei die Stromschleife (22) einen Leistungsabgriff (24) umfasst, welcher ausgebildet ist, den Messumformer (16) mit elektrischer Energie zu versorgen,
wobei die Stromschleife (22) einen Stromregelbaustein (26) umfasst, welcher in Reihe zu dem Leistungsabgriff (24) und dem Messumformer (16) geschaltet ist oder schaltbar ist,
**gekennzeichnet durch**
eine Konstantspannungsquelle (28), welche dem Stromregelbaustein (26) eine konstante Spannung bereitstellt.

2. Messumformerspeisegerät (14) nach Anspruch 1,
**dadurch gekennzeichnet, dass**
die effektive Kapazität der Stromschleife (22) kleiner als 10 nF, bevorzugt kleiner als 5 nF ist.

3. Messumformerspeisegerät (14) nach zumindest einem der vorstehenden Ansprüche,
**dadurch gekennzeichnet, dass**
der Leistungsabgriff (24) einen Transistor (25) umfasst, insbesondere einen npn-Transistor dessen Kollektor und Emitter zwischen einen der Anschlusskontakte (18) und den Stromregelbaustein (26) geschaltet sind.

4. Messumformerspeisegerät (14) nach zumindest einem der vorstehenden Ansprüche,
**dadurch gekennzeichnet, dass**
der Stromregelbaustein (26) ausgebildet ist, einen von den Messsignalen des Messumformers (16) abhängigen Strom in die Stromschleife (22) einzuprägen.

5. Messumformerspeisegerät (14) nach zumindest einem der vorstehenden Ansprüche,
**gekennzeichnet durch**
eine Modulationseinheit (32), welche ein auf den Strom der Stromschleife (22) aufzumodulierendes Datensignal erzeugt.

6. Messumformerspeisegerät (14) nach Anspruch 5,
**dadurch gekennzeichnet, dass**
die Modulationseinheit (32) mit dem Stromregelbaustein (26) gekoppelt ist, wobei der Stromregelbaustein (26) ausgebildet ist, das von der Modulationseinheit (32) vorgegebene Datensignal auf den Strom der Stromschleife (22) aufzumodulieren.

7. Messumformerspeisegerät (14) nach Anspruch 5 oder 6,
**dadurch gekennzeichnet, dass**
der Stromregelbaustein (26) und/oder der Messumformer (16) mittels jeweils einer Datenverbindung (34, 36) mit der Modulationseinheit (32) gekoppelt sind oder koppelbar sind.

8. Messumformerspeisegerät (14) nach zumindest einem der vorstehenden Ansprüche,
**gekennzeichnet durch**
eine Pufferkapazität (27), welche eine Größe von zumindest 100 nF, bevorzugt von zumindest 1 µF, aufweist und mit dem Leistungsabgriff (24) gekoppelt ist, um Verbrauchsspitzen des Messumformers (16) abzufangen.

9. System (10) mit zumindest einem Messumformerspeisegerät (14) gemäß einem der vorstehenden Ansprüche, einer mit den beiden Anschlusskontakten (18) elektrisch verbundenen Steuereinheit (12) und einem Messumformer (16), welcher von dem Messumformerspeisegerät (14) mit elektrischer Energie versorgt wird.

10. System nach Anspruch 9,
**dadurch gekennzeichnet, dass**
der Messumformer (16) ein Temperatursensor, ein Spannungssensor, ein Stromsensor, ein Durchflusssensor oder ein Annäherungssensor ist.

## Claims

1. A measurement transducer feed device (14) for process automation technology which is configured for the energy supply of a measurement transducer (16) and for forwarding measurement signals of the measurement transducer (16) to a control unit (12),
wherein the measurement transducer feed device (14) has at least two connecting contacts (18) which are configured for coupling the measurement transducer feed device (14) to the control unit (12), with a current loop (22) being formed between the two connecting contacts (18), and with the current loop (22) comprising a power tap (24) which is configured to supply the measurement transducer (16) with electrical energy; and
wherein the current loop (22) comprises a current regulation module (26) which is connected or connectable in series to the power tap (24) and to the measurement transducer (16),
**characterized by**
a constant power source (28) which provides a constant voltage to the current regulation module (26).

2. A measurement transducer feed device (14) in accordance with claim 1,
**characterized in that**
the effective capacitance of the current loop (22) is less than 10 nF, preferably less than 5 nF.

3. A measurement transducer feed device (14) in accordance with at least one of the preceding claims,
**characterized in that**
the power tap (24) comprises a transistor (25), in particular an NPN transistor, whose collector and emitter are connected between one of the connecting contacts (18) and the current regulation module (26).

4. A measurement transducer feed device (14) in accordance with at least one of the preceding claims,
**characterized in that**
the current regulation module (26) is configured to impart a current dependent on the measurement signals of the measurement transducer (16) into the current loop (22).

5. A measurement transducer feed device (14) in accordance with at least one of the preceding claims,
**characterized by**
a modulation unit (32) which generates a data signal to be modulated onto the current of the current loop (22).

6. A measurement transducer feed device (14) in accordance with claim 5,
**characterized in that**
the modulation unit (32) is coupled to the current regulation module (26), with the current regulation module (26) being configured to modulate the data signal predefined by the modulation unit (32) onto the current of the current loop (22).

7. A measurement transducer feed device (14) in accordance with claim 5 or claim 6,
**characterized in that**
the current regulation module (26) and/or the measurement transducer (16) is/are coupled or couplable to the modulation unit (32) by means of a respective data link (34, 36).

8. A measurement transducer feed device (14) in accordance with at least one of the preceding claims,
**characterized by**
a buffer capacity (27) which has a size of at least 100 nF, preferably of at least 1 µF, and which is coupled to the power tap (24) to take up consumption peaks of the measurement transducer (16).

9. A system (10) comprising at least one measurement transducer feed device (14) in accordance with any one of the preceding claims; a control unit (12) electrically connected to the two connecting contacts (18); and a measurement transducer (16) which is supplied with electrical energy by the measurement transducer feed device (14).

10. A system in accordance with claim 9,
**characterized in that**
the measurement transducer (16) is a temperature sensor, a voltage sensor, a current sensor, a flow sensor or a proximity sensor.

## Revendications

1. Appareil d'alimentation de transmetteur (14) pour la technique d'automatisation des processus, qui est réalisé pour alimenter en énergie un transmetteur (16) et pour transmettre des signaux de mesure du transmetteur (16) à une unité de commande (12),
dans lequel
l'appareil d'alimentation de transmetteur (14) présente au moins deux contacts de connexion (18) qui sont réalisés pour coupler l'appareil d'alimentation de transmetteur (14) à l'unité de commande (12),
une boucle de courant (22) est formée entre les deux contacts de connexion (18),
la boucle de courant (22) comprend une prise de puissance (24) qui est réalisée pour alimenter le transmetteur (16) en énergie électrique,
la boucle de courant (22) comprend un module de régulation de courant (26) qui est ou peut être connecté en série avec la prise de puissance (24) et avec le transmetteur (16),
**caractérisé par**
une source de tension constante (28) qui fournit une tension constante au module de régulation de courant (26).

2. Appareil d'alimentation de transmetteur (14) selon la revendication 1,
**caractérisé en ce que**
la capacité effective de la boucle de courant (22) est inférieure à 10 nF, de préférence inférieure à 5 nF.

3. Appareil d'alimentation de transmetteur (14) selon l'une au moins des revendications précédentes,
**caractérisé en ce que**
la prise de puissance (24) comprend un transistor (25), en particulier un transistor NPN, dont le collecteur et l'émetteur sont connectés entre l'un des contacts de connexion (18) et le module de régulation de courant (26).

4. Appareil d'alimentation de transmetteur (14) selon l'une au moins des revendications précédentes,
**caractérisé en ce que**
le module de régulation de courant (26) est réalisé pour injecter dans la boucle de courant (22) un courant dépendant des signaux de mesure du transmetteur (16).

5. Appareil d'alimentation de transmetteur (14) selon l'une au moins des revendications précédentes,
**caractérisé par**
une unité de modulation (32) qui génère un signal de données qui doit être modulé sur le courant de la boucle de courant (22).

6. Appareil d'alimentation de transmetteur (14) selon la revendication 5,
**caractérisé en ce que**
l'unité de modulation (32) est couplée au module de régulation de courant (26), le module de régulation de courant (26) étant réalisé pour moduler le signal de données imposé par l'unité de modulation (32) sur le courant de la boucle de courant (22).

7. Appareil d'alimentation de transmetteur (14) selon la revendication 5 ou 6,
**caractérisé en ce que**
le module de régulation de courant (26) et/ou le transmetteur (16) sont couplés ou peuvent être couplés à l'unité de modulation (32) par une liaison de données respective (34, 36).

8. Appareil d'alimentation de transmetteur (14) selon l'une au moins des revendications précédentes,
**caractérisé par**
une capacité tampon (27) qui présente une taille d'au moins 100 nF, de préférence d'au moins 1 µF, et qui est couplée à la prise de puissance (24) afin d'amortir des pics de consommation du transmetteur (16).

9. Système (10) comportant au moins un appareil d'alimentation de transmetteur (14) selon l'une des revendications précédentes, une unité de commande (12) reliée électriquement aux deux contacts de connexion (18) et un transmetteur (16) qui est alimenté en énergie électrique par l'appareil d'alimentation de transmetteur (14).

10. Système selon la revendication 9,
**caractérisé en ce que**
le transmetteur (16) est un capteur de température, un capteur de tension, un capteur de courant, un capteur de débit ou un capteur de proximité.
